# EUROPEAN PATENT APPLICATION

(11) **EP 4 568 030 A1**
(43) Date of publication of application: **11.06.2025**
(21) Application number: 23849743.2
(22) Date of filing: 01.06.2023
(51) Int. Cl.: H01S 5/042, H01S 5/343

(54) **SEMICONDUCTOR LAMINATE, SEMICONDUCTOR ELEMENT, AND METHOD FOR PRODUCING SEMICONDUCTOR LAMINATE**

(30) Priority: 04.08.2022 JP 2022125043
(71) Applicant: SUMITOMO ELECTRIC INDUSTRIES, LTD., Osaka-shi, Osaka 541-0041 (JP)
(72) Inventor: TAKADA, Kenshi, Osaka-shi, Osaka 541-0041 (JP); YOSHIMOTO, Susumu, Osaka-shi, Osaka 541-0041 (JP)
(74) Representative: Grünecker Patent- und Rechtsanwälte PartG mbB
(86) International application number: PCT/JP2023/020451
(87) International publication number: WO 2024/029182

(57) **Abstract**

This semiconductor laminate comprises a base layer, an active layer, an InP layer, a first semiconductor layer, a second semiconductor layer, and a third semiconductor layer. The InP layer has p-type conductivity. The first semiconductor layer is formed from InGaAsP including a first impurity that is a p-type impurity other than carbon, and in which the concentration of said first impurity is higher than that of carbon. The second semiconductor layer has a thickness of at least 20 nm and is formed from InGaAs including a second impurity that is a p-type impurity other than carbon. The third semiconductor layer is formed from InGaAs including carbon at a concentration of 3 × 10¹⁹cm⁻³ or more. The concentration of the second impurity in the semiconductor layer is lower than the concentration of carbon in the interface with the third semiconductor layer and higher than the concentration of carbon in the interface with the first semiconductor layer.

## Description

### TECHNICAL FIELD

The present disclosure relates to a semiconductor stack, an optical semiconductor device, and a method of manufacturing a semiconductor stack. This application claims priority based on Japanese Patent Application No. 2022-125043 filed on August 4, 2022, and the entire contents the Japanese patent application are incorporated herein by reference.

### BACKGROUND ART

In an optical semiconductor device such as a semiconductor light emitting element or a semiconductor light receiving element, an indium gallium arsenide (InGaAs) layer may be adopted as a contact layer disposed between an indium phosphide (InP) layer having a p-type conductivity and an electrode (see, for example, Patent Literature 1).

### CITATION LIST

### PATENT LITERATURE

Patent literature 1: Japanese Unexamined Patent Application Publication No. 2003-37337

### SUMMARY OF INVENTION

A semiconductor stack according to the present disclosure includes a base layer, an active layer, an InP layer, a first semiconductor layer, a second semiconductor layer, and a third semiconductor layer. The base layer is formed of a III-V compound semiconductor. The active layer is formed of a III-V compound semiconductor. The InP layer has a p-type conductivity. The first semiconductor layer is formed of InGaAsP (indium gallium arsenide phosphide) containing a first impurity which is a p-type impurity other than carbon at a higher concentration than carbon. The second semiconductor layer is formed of InGaAs containing a second impurity which is a p-type impurity other than carbon and having a thickness of 20 nm or more. The third semiconductor layer is formed of InGaAs containing carbon at a concentration of 3 × 10¹⁹ cm⁻³ or more. The base layer, the active layer, the InP layer, the first semiconductor layer, the second semiconductor layer, and the third semiconductor layer are stacked in this order. The second semiconductor layer is in contact with the first semiconductor layer and the third semiconductor layer. A concentration of the second impurity in the second semiconductor layer is lower than a concentration of carbon at an interface with the third semiconductor layer and is higher than the concentration of carbon at an interface with the first semiconductor layer.

A method of manufacturing a semiconductor stack according to the present disclosure includes a first step, a second step, a third step, a fourth step, a fifth step, a sixth step, and a seventh step. In the first step, a base layer formed of a III-V compound semiconductor is prepared. In the second step, an active layer formed of a III-V compound semiconductor is formed. In the third step, an InP layer having a p-type conductivity is formed. In the fourth step, a first semiconductor layer formed of InGaAsP containing a first impurity which is a p-type impurity other than carbon at a higher concentration than carbon is formed. In the fifth step, a second semiconductor layer formed of InGaAs containing a second impurity which is a p-type impurity other than carbon and having a thickness of 20 nm or more is formed at a first temperature. In the sixth step, the base layer, the active layer, the InP layer, the first semiconductor layer, and the second semiconductor layer are cooled from the first temperature to a second temperature lower than the first temperature. In the seventh step, a third semiconductor layer formed of InGaAs containing carbon at a concentration of 3 × 10¹⁹ cm⁻³ or more is formed at the second temperature. The first step, the second step, the third step, the fourth step, the fifth step, the sixth step, and the seventh step are performed in this order.

### BRIEF DESCRIPTION OF THE DRAWINGS

FIG. 1 is a schematic cross-sectional view showing the structure of a semiconductor stack according to a first embodiment.
FIG. 2 is a schematic cross-sectional view showing the structure of the semiconductor laser according to the first embodiment.
FIG. 3 is a flowchart showing an outline of a method of manufacturing a semiconductor stack and a semiconductor laser according to a first embodiment.
FIG. 4 is a schematic cross-sectional view showing the structure of a semiconductor stack according to a second embodiment.
FIG. 5 is a schematic cross-sectional view showing the structure of a semiconductor stack according to a third embodiment.
FIG. 6 is a diagram showing the distribution of carbon and zinc concentrations in the depth direction of a contact layer.
FIG. 7 is a diagram showing changes in the flow rate of TBAs in steps S60 to S80.
FIG. 8 is a graph showing the relationship between the flow rate of TBAs and the surface roughness RMS of the third semiconductor layer in the step S70.

### DETAILED DESCRIPTION

### [Problems to be Solved by Present Disclosure]

According to the studies of the inventors, in a structure in which an InGaAs layer is adopted as a contact layer disposed between an InP layer having p-type conductivity and an electrode, when carbon (C) which is a p-type impurity is doped into the InGaAs layer at a high concentration in order to reduce the contact resistance between the electrode and the contact layer, a problem may occur in that the resistance of the optical semiconductor device increases.

Thus, it is an object of the present disclosure to provide a semiconductor stack, an optical semiconductor device, and a method of manufacturing a semiconductor stack, which are capable of reducing the contact resistance between an electrode and a contact layer and also reducing the resistance of the optical semiconductor device as a whole in a structure in which an InGaAs layer is adopted as the contact layer disposed between an InP layer having a p-type conductivity and the electrode.

### [Advantageous Effects of Present Disclosure]

According to the semiconductor stack and the method of manufacturing the same, in a structure in which an InGaAs layer is adopted as a contact layer disposed between an InP layer having a p-type conductivity and an electrode, contact resistance between the electrode and the contact layer can be reduced. Furthermore, the resistance of the optical semiconductor device as a whole can be reduced.

### [Description of Embodiments of Present Disclosure]

First, embodiments of the present disclosure will be listed and described.
(1) A semiconductor stack of the present disclosure includes a base layer, an active layer, an InP layer, a first semiconductor layer, a second semiconductor layer, and a third semiconductor layer. The base layer is formed of a III-V compound semiconductor. The active layer is formed of a III-V compound semiconductor. The InP layer has a p-type conductivity. The first semiconductor layer is formed of InGaAsP containing a first impurity which is a p-type impurity other than carbon at a higher concentration than carbon. The second semiconductor layer is formed of InGaAs containing a second impurity which is a p-type impurity other than carbon and having a thickness of 20 nm or more. The third semiconductor layer is formed of InGaAs containing carbon at a concentration of 3 × 10¹⁹ cm⁻³ or more. The base layer, the active layer, the InP layer, the first semiconductor layer, the second semiconductor layer, and the third semiconductor layer are stacked in this order. The second semiconductor layer is in contact with the first semiconductor layer and the third semiconductor layer. A concentration of the second impurity in the second semiconductor layer is lower than a concentration of carbon at an interface with the third semiconductor layer and is higher than the concentration of carbon at an interface with the first semiconductor layer.

The semiconductor stack of the present disclosure includes a third semiconductor layer formed of InGaAs, corresponding to the structure of an optical semiconductor device in which an InGaAs layer is adopted as a contact layer disposed between an InP layer having a p-type conductivity and an electrode. The third semiconductor layer includes carbon with a high concentration (3 × 10¹⁹ cm⁻³ or more), and thus a low contact resistance with the electrode is achieved. Here, when the third semiconductor layer is disposed so as to be in contact with the InP layer, the resistance of the optical semiconductor device (resistance in the thickness direction of the semiconductor stack) increases due to the discontinuity of the energy band between the two layers. In the semiconductor stack of the present disclosure, a first semiconductor layer formed of InGaAsP containing a first impurity at a higher concentration than carbon is disposed between the InP layer and the third semiconductor layer. This avoids the energy band from becoming discontinuous.

However, when the first semiconductor layer and the third semiconductor layer are disposed so as to be in contact with each other, carbon included in the third semiconductor layer at a high concentration may be diffused into the first semiconductor layer. When carbon enters the first semiconductor layer formed of InGaAsP, the conductivity of the first semiconductor layer becomes n-type, and the resistance of the optical semiconductor device may increase. In the semiconductor stack of the present disclosure, a second semiconductor layer that is formed of InGaAs containing a second impurity which is a p-type impurity other than carbon and having a thickness of 20 nm or more is disposed between the first semiconductor layer and the third semiconductor layer. In the second semiconductor layer, the concentration of carbon diffused from the third semiconductor layer varies in the film thickness direction. The concentration of the second impurity in the second semiconductor layer is lower than the concentration of carbon at the interface with the third semiconductor layer and is higher than the concentration of carbon at the interface with the first semiconductor layer. The concentration of carbon diffused from the third semiconductor layer is significantly reduced in the second semiconductor layer, and thus the diffusion of carbon from the third semiconductor layer to the first semiconductor layer is suppressed. As a result, an increase in the resistance of the optical semiconductor device can be suppressed.

As described above, the semiconductor stack of the present disclosure includes the first semiconductor layer, the second semiconductor layer, and the third semiconductor layer. As a result, according to the semiconductor stack of the present disclosure, in a structure in which an InGaAs layer is adopted as a contact layer disposed between an InP layer having a p-type conductivity and an electrode, contact resistance between the electrode and the contact layer can be reduced. Furthermore, the resistance of the optical semiconductor device as a whole can be reduced.

(2) In the above (1), a surface roughness of a main surface of the third semiconductor layer opposite to the second semiconductor layer may be 0.3 nm or less in terms of root mean square roughness. With this structure, it is possible to suppress a decrease in the light emission efficiency of the light emitting element and the light receiving sensitivity of the light receiving element due to defects in the crystal.

(3) In the above (1) or (2), the first impurity may be Zn (zinc). Zn is suitable as a p-type impurity contained in the first semiconductor layer.

(4) In any one of the above (1) to (3), the second impurity may be Zn. Zn is suitable as a p-type impurity contained in the second semiconductor layer.

(5) In any one of the above (1) to (4), a composition of InGaAsP forming the first semiconductor layer is such that a bandgap may be smaller in a region closer to the second semiconductor layer than to the InP layer in a thickness direction of the first semiconductor layer. With this structure, it is possible to suppress a sharp change in the bandgap in the thickness direction of the semiconductor stack.

(6) In the above (5), the composition of InGaAsP forming the first semiconductor layer may change stepwise in the thickness direction of the first semiconductor layer such that atomic fractions of Ga and As in InGaAsP increase toward the second semiconductor layer. With this structure, the structure of the above (5) can be easily achieved.

(7) In the above (5), the composition of InGaAsP forming the first semiconductor layer may change continuously in the thickness direction of the first semiconductor layer such that atomic fractions of Ga and As in InGaAsP increase toward the second semiconductor layer. With this structure, the structure of the above (5) can be easily achieved.

(8) An optical semiconductor device of the present disclosure includes the semiconductor stack described in any one of the above (1) to (7) and an electrode disposed on the third semiconductor layer. An optical semiconductor device of the present disclosure includes the semiconductor stack of the present disclosure, and thus can reduce contact resistance between an electrode and a contact layer in a structure in which an InGaAs layer is adopted as the contact layer disposed between an InP layer having a p-type conductivity and the electrode. Furthermore, the resistance of the optical semiconductor device as a whole can be reduced.

(9) A method of manufacturing a semiconductor stack of the present disclosure includes a first step, a second step, a third step, a fourth step, a fifth step, a sixth step, and a seventh step. In the first step, a base layer formed of a III-V compound semiconductor is prepared. In the second step, an active layer formed of a III-V compound semiconductor is formed. In the third step, an InP layer having a p-type conductivity is formed. In the fourth step, a first semiconductor layer formed of InGaAsP containing a first impurity which is a p-type impurity other than carbon at a higher concentration than carbon is formed. In the fifth step, a second semiconductor layer formed of InGaAs containing a second impurity which is a p-type impurity other than carbon and having a thickness of 20 nm or more is formed at a first temperature. In the sixth step, the base layer, the active layer, the InP layer, the first semiconductor layer, and the second semiconductor layer are cooled from the first temperature to a second temperature lower than the first temperature. In the seventh step, a third semiconductor layer formed of InGaAs containing carbon at a concentration of 3 × 10¹⁹ cm⁻³ or more is formed at the second temperature. The first step, the second step, the third step, the fourth step, the fifth step, the sixth step, and the seventh step are performed in this order.

According to the method of manufacturing a semiconductor stack of the present disclosure, the semiconductor stack of the present disclosure can be easily manufactured.

(10) In the above (9), in the sixth step, a source gas of As may be supplied at a flow rate equal to or higher than that in the fifth step. This can reduce the surface roughness of the main surface of the third semiconductor layer opposite to second semiconductor layer.

(11) In the above (9) or (10), a surface roughness of a main surface of the third semiconductor layer opposite to the second semiconductor layer may be 0.3 nm or less in terms of root mean square roughness. This can suppress a decrease in the light emission efficiency of the light emitting element and the light receiving sensitivity of the light receiving element due to defects in the crystal.

### [Details of Embodiments of Present Disclosure]

Next, embodiments of a semiconductor stack and an optical semiconductor device according to the present disclosure will be described below with reference to the drawings. In the drawings, the same or corresponding parts are denoted by the same reference characters, and description thereof will not be repeated.

### (First Embodiment)

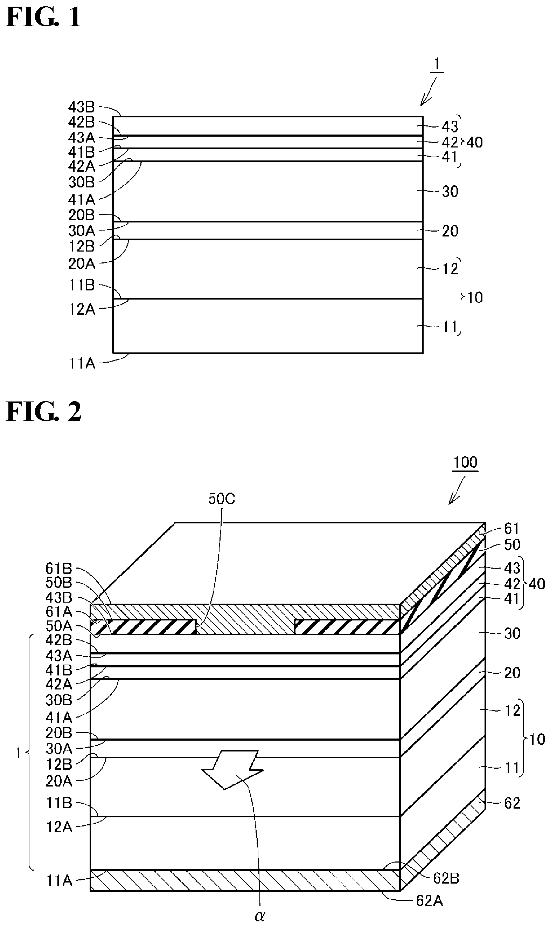

Referring to FIG. 1, a semiconductor stack 1 according to the first embodiment includes a substrate 11, an n-type cladding layer 12, an active layer 20, an InP layer 30, a first semiconductor layer 41, a second semiconductor layer 42, and a third semiconductor layer 43. Active layer 20 includes a quantum well structure. InP layer 30 is a p-type cladding layer. First semiconductor layer 41 is a first contact layer. Second semiconductor layer 42 is a second contact layer. Third semiconductor layer 43 is a third contact layer. Substrate 11 and n-type cladding layer 12 form a base layer 10. First semiconductor layer 41, second semiconductor layer 42, and third semiconductor layer 43 form a p-type contact layer 40.

Substrate 11 is formed of a III-V compound semiconductor. Substrate 11 has a diameter of 50 mm or more, for example, 3 inches. Substrate 11 can have a diameter of 100 mm or more (e.g., 4 inches), 120 mm or more (e.g., 5 inches), or 150 mm or more (e.g., 6 inches), in order to improve the productivity and yield of the optical semiconductor element using semiconductor stack 1. As the III-V compound semiconductor forming substrate 11, for example, InP can be adopted. Substrate 11 has a first main surface 11A and a second main surface 11B. For example, an InP having an n-type conductivity (n-InP) is adopted as the compound semiconductor forming substrate 11. As the n-type impurity contained in substrate 11, for example, S (sulfur) can be adopted.

N-type cladding layer 12 is disposed so as to be in contact with second main surface 11B of substrate 11. N-type cladding layer 12 is formed of a III-V compound semiconductor. As the III-V compound semiconductor forming n-type cladding layer 12, for example, InP can be adopted. N-type cladding layer 12 has a first main surface 12A and a second main surface 12B. For example, an InP having an n-type conductivity (n-InP) is adopted as the compound semiconductor forming n-type cladding layer 12. As the n-type impurity contained in n-type cladding layer 12, for example, S can be adopted. First main surface 12A of n-type cladding layer 12 is in contact with second main surface 11B of substrate 11.

Active layer 20 is disposed so as to be in contact with second main surface 12B of n-type cladding layer 12. Active layer 20 has a structure in which a plurality of element layers formed of a III-V compound semiconductor are stacked. More specifically, active layer 20 may be, for example, a separate confinement heterostructure multiple quantum well (SCH-MQW) including an InGaAs layer and an InGaAsP layer. Active layer 20 includes a first main surface 20A and a second main surface 20B. First main surface 20A of active layer 20 is in contact with second main surface 12B of n-type cladding layer 12.

InP layer 30 is disposed so as to be in contact with second main surface 20B of active layer 20. InP layer 30 is formed of an InP having a p-type conductivity. InP layer 30 can function as a p-type cladding layer. InP layer 30 has a first main surface 30A and a second main surface 30B. As the p-type impurity contained in InP layer 30, for example, Zn can be adopted. InP layer 30 is in contact with second main surface 20B of active layer 20 at first main surface 30A.

First semiconductor layer 41 is disposed so as to be in contact with second main surface 30B of InP layer 30. First semiconductor layer 41 is formed of InGaAsP containing a first impurity which is a p-type impurity other than carbon at a higher concentration than carbon. As the first impurity, for example, Zn, Be (beryllium), or Mg (magnesium) can be adopted. First semiconductor layer 41 has a first main surface 41A and a second main surface 41B. First main surface 41A of first semiconductor layer 41 is in contact with second main surface 30B of InP layer 30.

Second semiconductor layer 42 is disposed so as to be in contact with second main surface 41B of first semiconductor layer 41. Second semiconductor layer 42 is formed of InGaAs containing a second impurity which is a p-type impurity other than carbon. As the second impurity, for example, Zn, Be, or Mg can be adopted. Second semiconductor layer 42 has a thickness of 20 nm or more. Second semiconductor layer 42 has a first main surface 42A and a second main surface 42B. First main surface 42A of second semiconductor layer 42 and second main surface 41B of first semiconductor layer 41 are in contact with each other. The first impurity and the second impurity may be the same element or different elements.

Third semiconductor layer 43 is disposed so as to be in contact with second main surface 42B of second semiconductor layer 42. Third semiconductor layer 43 is formed of InGaAs containing carbon at a concentration of 3 × 10¹⁹ cm⁻³ or more. Third semiconductor layer 43 has a first main surface 43A and a second main surface 43B. First main surface 43A of third semiconductor layer 43 and second main surface 42B of second semiconductor layer 42 are in contact with each other.

In the present embodiment, the concentration of the second impurity in second semiconductor layer 42 is lower than the concentration of carbon at the interface with third semiconductor layer 43, and is higher than the concentration of carbon at the interface with first semiconductor layer 41.

In semiconductor stack 1 of the present embodiment, third semiconductor layer 43 contains carbon at a high concentration of 3 × 10¹⁹ cm⁻³ or more, and thus the contact resistance between third semiconductor layer 43 and the electrode (p-electrode 61) to be formed on third semiconductor layer 43 is reduced. In semiconductor stack 1 of the present embodiment, first semiconductor layer 41 formed of InGaAsP containing a first impurity at a higher concentration than carbon is disposed between InP layer 30 and third semiconductor layer 43. This prevents the energy band from being discontinuous between InP layer 30 and third semiconductor layer 43. Furthermore, in semiconductor stack 1 of the present embodiment, second semiconductor layer 42, which is formed of InGaAs containing a second impurity which is a p-type impurity other than carbon and having a thickness of 20 nm or more, is disposed between first semiconductor layer 41 and third semiconductor layer 43. The concentration of the second impurity in second semiconductor layer 42 is lower than the concentration of carbon at the interface with third semiconductor layer 43 and is higher than the concentration of carbon at the interface with first semiconductor layer 41. This suppresses diffusion of carbon from third semiconductor layer 43 to first semiconductor layer 41, and suppresses an increase in resistance in the thickness direction of semiconductor stack 1.

As described above, semiconductor stack 1 of the present embodiment includes first semiconductor layer 41, second semiconductor layer 42, and third semiconductor layer 43, and thus, in a structure in which third semiconductor layer 43 formed of InGaAs is adopted as a contact layer disposed between InP layer 30 having a p-type conductivity and the electrode, semiconductor stack 1 can reduce the contact resistance between the electrode and third semiconductor layer 43 and also reduce the resistance of the entire optical semiconductor device.

From the viewpoint of more reliably suppressing the diffusion of carbon from third semiconductor layer 43 to first semiconductor layer 41, second semiconductor layer 42 may have a thickness of 20 nm or more. From the viewpoint of light absorption in the second contact layer, second semiconductor layer 42 may have a thickness of 40 nm or less, and 30 nm or less.

From the viewpoint of more reliably reducing the contact resistance between the electrode and third semiconductor layer 43, the concentration of carbon included in third semiconductor layer 43 may be 5 × 10¹⁹ cm⁻³ or more. From the viewpoint of suppressing the deterioration of the crystallinity of third semiconductor layer 43, the concentration of carbon included in third semiconductor layer 43 may be 2 × 10²⁰ cm⁻³ or less, and may be 1 × 10²⁰ cm⁻³ or less.

In semiconductor stack 1, a surface roughness of second main surface 43B of third semiconductor layer 43, which is a main surface opposite to second semiconductor layer 42 may be 0.3 nm or less in terms of root mean square roughness (RMS). This can suppress a decrease in the light emission efficiency of the light emitting element and the light receiving sensitivity of the light receiving element due to defects in the crystal.

Next, a semiconductor laser, which is a semiconductor light emitting device, will be described as an example of an optical semiconductor device that can be manufactured using semiconductor stack 1. Referring to FIG. 2, a semiconductor laser 100 according to the present embodiment is manufactured using semiconductor stack 1 according to the present embodiment, and includes substrate 11, n-type cladding layer 12, active layer 20, InP layer 30, first semiconductor layer 41, second semiconductor layer 42, and third semiconductor layer 43.

Semiconductor laser 100 includes an insulating film 50, p-electrode 61, and an n-electrode 62. Insulating film 50 is disposed so as to be in contact with second main surface 43B of third semiconductor layer 43. Insulating film 50 is formed of an insulator such as silicon nitride or silicon oxide. Insulating film 50 has a first main surface 50A and a second main surface 50B. First main surface 50A of insulating film 50 may be in contact with second main surface 43B of third semiconductor layer 43. Insulating film 50 has an opening 50C formed therein, which penetrates insulating film 50 in the thickness direction.

P-electrode 61 is disposed so as to be in contact with second main surface 50B of insulating film 50. P-electrode 61 is formed of a conductor such as metal. More specifically, p-electrode 61 can be formed of a metal layer in which a Ti (titanium) layer, a Pt (platinum) layer, and an Au (gold) layer are stacked in this order, for example. P-electrode 61 fills opening 50C formed in insulating film 50. As a result, p-electrode 61 is in contact with second main surface 43B of third semiconductor layer 43 exposed in opening 50C. P-electrode 61 is in ohmic contact with third semiconductor layer 43.

N-electrode 62 is disposed so as to be in contact with first main surface 11A of substrate 11. N-electrode 62 is formed of a conductor such as metal. More specifically, n-electrode 62 can be formed of a metal layer in which, for example, a Ti layer, a Pt layer, and an Au layer are stacked in this order. N-electrode 62 is in contact with first main surface 11A of substrate 11. N-electrode 62 is in ohmic contact with substrate 11. Semiconductor laser 100 is an edge-emitting laser diode having a Fabry-Perot structure.

When a voltage is applied across p-electrode 61 and n-electrode 62, a current flows across p-electrode 61 and n-electrode 62. At this time, holes are injected into active layer 20 from p-electrode 61, and electrons are injected into active layer 20 from n-electrode 62. Then, the holes and the electrons are recombined in active layer 20, and light is generated. The generated light is confined in active layer 20 sandwiched between n-type cladding layer 12 and InP layer 30 functioning as a p-type cladding layer in the thickness direction of active layer 20. This light is repeatedly reflected between the end faces of active layer 20. As a result, the light having the same phase is amplified, and laser oscillation is achieved. Then, laser light is emitted along an arrow α.

Semiconductor laser 100 of the present embodiment includes semiconductor stack 1 of the present embodiment. Thus, semiconductor laser 100 is a semiconductor laser in which the contact resistance between p-electrode 61 and third semiconductor layer 43 is reduced and the resistance of entire semiconductor laser 100 is also reduced in a structure in which third semiconductor layer 43 formed of InGaAs is adopted as a contact layer disposed between InP layer 30 having a p-type conductivity and p-electrode 61.

Next, an outline of a method of manufacturing semiconductor stack 1 and semiconductor laser 100 according to the present embodiment will be described with reference to FIGS. 1 to 3.

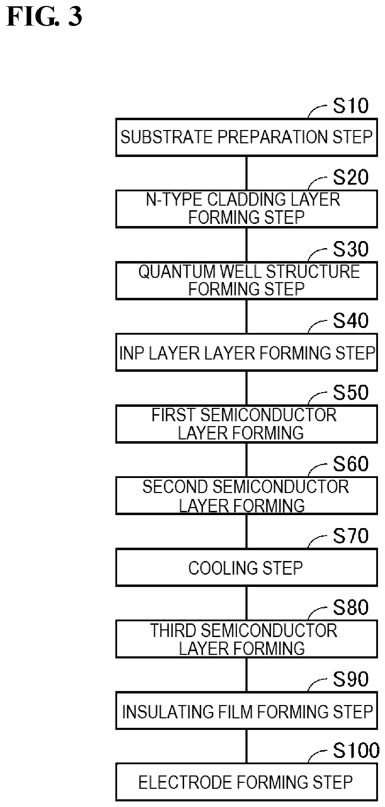

Referring to FIG. 3, in the method of manufacturing semiconductor stack 1 and semiconductor laser 100 according to the present embodiment, a substrate preparation step is first performed as a step S10. In the step S10, referring to FIG. 1, substrate 11 formed of an InP having an n-type conductivity, for example, is prepared. More specifically, substrate 11 formed of InP is obtained by slicing an ingot formed of InP. After the surface of substrate 11 is polished, substrate 11 in which second main surface 11B are flat and clean of through a process such as cleaning is prepared.

Next, an n-type cladding layer forming step is performed as a step S20. In the step S20, n-type cladding layer 12 formed of, for example, n-InP which is a III-V compound semiconductor is formed by a vapor phase growth method so as to be in contact with second main surface 11B of substrate 11. In the formation of n-type cladding layer 12, for example, TMIn (trimethylindium) can be used as a raw material of In. As a raw material of P, for example, TBP (tertiary butyl phosphine) can be used. The steps S10 and S20 are the first step for forming base layer 10.

Next, a quantum well structure forming step is performed as a step S30. In the step S30, active layer 20, which is an SCH-MQW including, for example, an InGaAs layer and an InGaAsP layer, is formed by vapor phase growth method so as to be in contact with second main surface 12B of n-type cladding layer 12. In the formation of active layer 20, for example, TMIn can be used as a raw material of In. As a raw material of Ga, for example, TEGa (triethyl gallium) can be used. As a raw material of As, TBAs (tertiary butyl arsine) or the like can be used. As a raw material of P, for example, TBP (tertiary butyl phosphine) can be used. The step S30 is a second step of forming an active layer.

Next, an InP layer forming step is performed as a step S40. In the step S40, InP layer 30 functioning as a p-type cladding layer is formed by vapor phase growth method so as to be in contact with second main surface 20B of active layer 20. In the formation of InP layer 30, for example, TMIn can be used as a raw material of In. As a raw material of P, for example, TBP can be used. The step S40 is a third step of forming InP layer 30 having a p-type conductivity.

Next, a first semiconductor layer forming step is performed as a step S50. In the step S50, first semiconductor layer 41, which is a first contact layer, is formed so as to be in contact with second main surface 30B of InP layer 30. In the formation of first semiconductor layer 41, for example, TMIn can be used as a raw material of In. As a raw material of Ga, for example, TEGa can be used. As a raw material of As, TBAs or the like can be used. As a raw material of P, for example, TBP can be used. The step S50 is the fourth step of forming first semiconductor layer 41 formed of InGaAsP containing a first impurity which is a p-type impurity other than carbon at a higher concentration than carbon. The first impurity is, for example, Zn. As a raw material of Zn, for example, DEZn (Diethylzinc) or DMZn (Dimethylzinc) can be used.

Next, a second semiconductor layer forming step is performed as a step S60. In the step S60, second semiconductor layer 42, which is a second contact layer, is formed to have a thickness of 20 nm or more so as to be in contact with second main surface 41B of first semiconductor layer 41. Second semiconductor layer 42 is formed at the first temperature. In the formation of second semiconductor layer 42, for example, TMIn can be used as a raw material of In. As a raw material of Ga, for example, TEGa can be used. As a raw material of As, TBAs or the like can be used. The step S60 is the fifth step of forming, at the first temperature, a second semiconductor layer formed of InGaAs containing a second impurity which is a p-type impurity other than carbon and having a thickness of 20 nm or more. The second impurity is, for example, Zn. As a raw material of Zn, for example, DEZn (Diethylzinc) or DMZn (Dimethylzinc) can be used.

Next, a cooling step is performed as a step S70. In the step S70, the structure including substrate 11, n-type cladding layer 12, active layer 20, InP layer 30, first semiconductor layer 41, and second semiconductor layer 42 obtained by performing the steps S10 to S60 is cooled from the first temperature to a second temperature lower than the first temperature. The step S70 corresponds to the sixth step which is a cooling step.

Next, a third semiconductor layer forming step is performed as a step S80. In the step S80, third semiconductor layer 43 functioning as the third contact layer is formed so as to be in contact with second main surface 42B of second semiconductor layer 42. Third semiconductor layer 43 is formed at the second temperature lower than the first temperature. In the formation of third semiconductor layer 43, for example, TMIn can be used as a raw material of In. As a raw material of Ga, for example, TEGa can be used. As a raw material of As, TBAs or the like can be used. The step S80 is a seventh step of forming, at the second temperature, a third semiconductor layer formed of InGaAs containing carbon at a concentration of 3 × 10¹⁹ cm⁻³ or more. As a raw material of carbon, for example, CBr₄ (carbon tetrabromide) can be used.

By the steps S60 to S80 of the present embodiment, second semiconductor layer 42 is formed such that the concentration of the second impurity in second semiconductor layer 42 is lower than the concentration of carbon at the interface with third semiconductor layer 43 and is higher than the concentration of carbon at the interface with first semiconductor layer 41. By performing above the steps S10 to S80, semiconductor stack 1 of the present embodiment is completed.

In the step S70, the source gas of As may be supplied at a flow rate equal to or higher than that in the step S60. Thus, the surface roughness of second main surface 43B of third semiconductor layer 43 may be reduced. The reason why the surface roughness can be reduced is considered as follows. The step S80 is performed at the second temperature lower than the first temperature, at which the step S60 is performed. The first temperature is, for example, 480°C to 520°C. The second temperature is, for example, 380°C to 420°C. The difference between the first temperature and the second temperature is, for example, about 100°C. Thus, in the step S70, the cooling (temperature decrease) step is performed. At this time, according to the study of the present inventors, when the source gas of As is supplied at a flow rate less than that in the step S60, surface roughness occurs in second semiconductor layer 42 formed in the step S60. As a result, defects in third semiconductor layer 43 formed on second semiconductor layer 42 increase, and surface roughness also occurs in second main surface 43B of third semiconductor layer 43, which is the surface of semiconductor stack 1. Interface defects between second semiconductor layer 42 and third semiconductor layer 43 may act as non-radiative recombination centers, causing a reduction in the light emission efficiency of the device. Although not certain, the cause of the surface roughness is considered to be the separation of As from second semiconductor layer 42. According to the studies of the present inventors, the source gas of As is supplied in the step S70 at a flow rate equal to or higher than that in the step S60, whereby the separation of As is reduced and the surface roughness is suppressed.

Further, semiconductor laser 100 can be manufactured using semiconductor stack 1 by performing the following steps. Referring to FIG. 3, an insulating film forming step is performed as a step S90 on semiconductor stack 1 obtained by performing the steps S10 to S80. In the step S90, referring to FIG. 2, insulating film 50 is formed on second main surface 43B of third semiconductor layer 43. Specifically, insulating film 50 formed of an insulator such as silicon oxide or silicon nitride is formed by, for example, CVD (Chemical Vapor Deposition).

Next, an electrode forming step is performed as a step S100. In the step S100, referring to FIG. 2, p-electrode 61 and n-electrode 62 are formed on semiconductor stack 1 on which insulating film 50 is formed. Specifically, referring to FIG. 2, a mask having an opening on a region where opening 50C of insulating film 50 is to be formed is formed on insulating film 50. Then, opening 50C is formed in insulating film 50 using the mask. Thereafter, p-electrode 61 and n-electrode 62 formed of an appropriate conductor are formed by, for example, a vapor deposition method. Semiconductor laser 100 according to the present embodiment is completed by the above steps. Thereafter, semiconductor laser 100 is divided into individual elements by dicing, for example.

### (Second Embodiment)

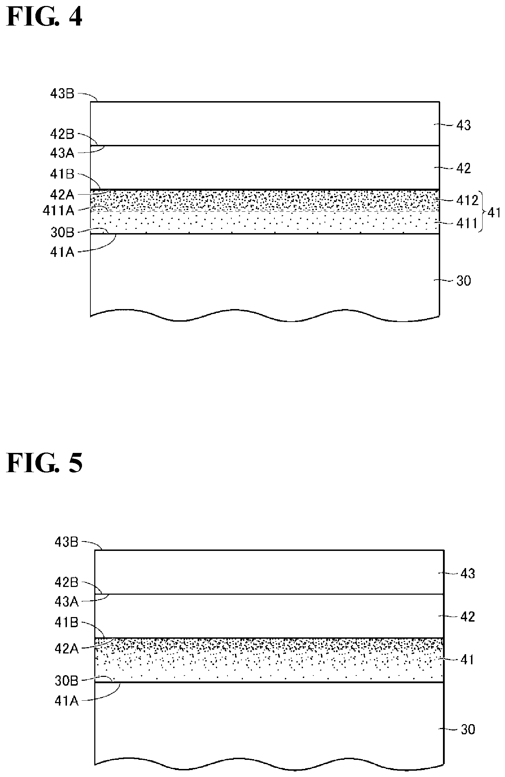

Next, a second embodiment which is another embodiment of the semiconductor stack and the optical semiconductor device of the present disclosure will be described. FIG. 4 is a cross-sectional view showing an enlarged view of the part at or near a contact layer of a semiconductor stack and an optical semiconductor device according to the second embodiment. Referring to FIGS. 4, 1, and 2, the semiconductor stack and the optical semiconductor device of the second embodiment basically have the same structures as those of the first embodiment, and can be manufactured in the same manner as the first embodiment while achieving the same effects. However, the second embodiment is different from the first embodiment in the structure of first semiconductor layer 41.

Specifically, referring to FIG. 4, the composition of InGaAsP forming first semiconductor layer 41 of the second embodiment changes in the thickness direction of first semiconductor layer 41 so that the bandgap is smaller in a region closer to second semiconductor layer 42 than to InP layer 30. In the present embodiment, first semiconductor layer 41 includes a first layer 411 and a second layer 412 disposed in contact with first layer 411. The atomic fraction of Ga and As in InGaAsP forming second layer 412 is larger than the atomic fraction of Ga and As in InGaAsP forming first layer 411. That is, the composition of InGaAsP forming first semiconductor layer 41 changes stepwise in the thickness direction of first semiconductor layer 41. The composition of InGaAsP forming first semiconductor layer 41 is constant in first layer 411 and second layer 412. With this configuration, in the second embodiment, it is possible to suppress a sharp change in the bandgap in the thickness direction of semiconductor stack 1. Semiconductor stack 1 and semiconductor laser 100 according to the second embodiment can be manufactured by changing the flow rate of the source gas in a stepwise manner in the step S50 of forming first semiconductor layer 41.

### (Third Embodiment)

Next, a third embodiment which is still another embodiment of the semiconductor stack and the optical semiconductor device of the present disclosure will be described. FIG. 5 is a cross-sectional view showing an enlarged view of the vicinity of a contact layer of a semiconductor stack and an optical semiconductor device according to the third embodiment. Referring to FIGS. 5, 1 and 2, the semiconductor stack and the optical semiconductor device of the third embodiment basically have the same structures as those of the first embodiment, and can be manufactured in the same manner as the first embodiment while achieving the same effects. However, the third embodiment is different from the first embodiment in the structure of first semiconductor layer 41.

Specifically, referring to FIG. 5, the composition of InGaAsP forming first semiconductor layer 41 of the third embodiment is changed in the thickness direction of first semiconductor layer 41 so that the bandgap is smaller in a region closer to second semiconductor layer 42 than to InP layer 30. In the present embodiment, the composition of InGaAsP forming first semiconductor layer 41 changes continuously in the thickness direction of first semiconductor layer 41. More specifically, in the present embodiment, the atomic fractions of Ga and As in InGaAsP forming first semiconductor layer 41 increase toward second semiconductor layer 42. With this structure, in the third embodiment, it is possible to suppress a sharp change in the bandgap in the thickness direction of semiconductor stack 1. Semiconductor stack 1 and semiconductor laser 100 according to the third embodiment can be manufactured by continuously changing the flow rate of the source gas in step the S50 of forming first semiconductor layer 41.

### EXAMPLES

### (Measurement of Impurity Concentration in Second Semiconductor Layer)

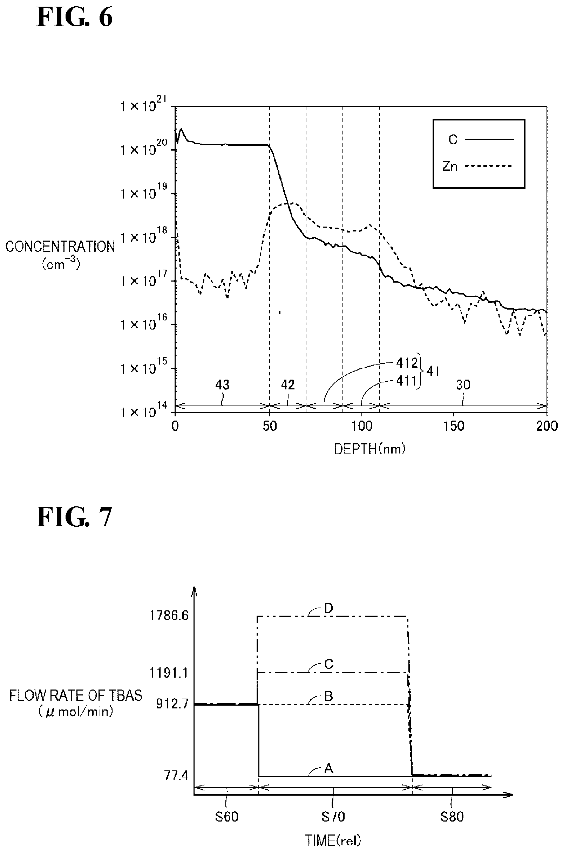

Semiconductor stack 1 of the second embodiment was manufactured in accordance with the method of manufacturing the semiconductor stack described in the above embodiment, and an experiment was conducted to measure the concentration of Zn and the concentration of carbon, which are the second impurity in second semiconductor layer 42. Specifically, an experiment was conducted to measure the concentration of Zn and carbon in the depth direction of semiconductor stack 1 from second main surface 43B of third semiconductor layer 43 using an ECV (Electrochemical Capacitance-Voltage) measuring device ECV-pro manufactured by Nanometrics Inc. The results of the experiment are shown in FIG. 6.

In FIG. 6, the horizontal axis corresponds to the depth from second main surface 43B. The vertical axis corresponds to the concentration of Zn and carbon. In FIG. 6, the solid line indicates the concentration of carbon, and the dashed line indicates the concentration of Zn. In FIG. 6, the same reference signs as those in FIG. 4 are used to indicate the depth of each layer of semiconductor stack 1.

Referring to FIG. 6, in second semiconductor layer 42, the curve corresponding to the concentration of Zn and the curve corresponding to the concentration of carbon intersect. The concentration of Zn in second semiconductor layer 42 is lower than the concentration of carbon at the interface with third semiconductor layer 43 and is higher than the concentration of carbon at the interface with first semiconductor layer 41. From this, it is confirmed that the semiconductor stack of the present disclosure can be manufactured by the method of manufacturing the semiconductor stack of the present disclosure.

### (Investigation of Influence of Flow Rate of Source Gas of As in Cooling Step on Surface Roughness)

An experiment was performed to investigate the influence of the flow rate of the source gas (TBAs) of As in the cooling step (sixth step; step S70) on the surface roughness of third semiconductor layer 43. The experimental procedure is as follows.

Semiconductor stack 1 of the second embodiment was manufactured in accordance with the method of manufacturing the semiconductor stack described in the above embodiment. The thicknesses of first layer 411, second layer 412, second semiconductor layer 42, and third semiconductor layer 43 were 20 nm, 20 nm, 20 nm, and 50 nm, respectively. The growth temperatures of second semiconductor layer 42 in the step S60 and third semiconductor layer 43 in the step S80 were 500°C and 400°C, respectively. In the step S70, the temperature was decreased from 500°C to 400°C. The flow rate of TBAs in the steps S60 to S80 was as shown in FIG. 7. Referring to FIG. 7, the flow rate of TBAs in the step S60 was 912.7 µmol/min, and the flow rate of TBAs in the step S80 was 77.4 µmol/min. The flow rate of TBAs in the step S70 was changed in four stages of 77.4 µmol/min (condition A), 912.7 µmol/min (condition B), 1191.1 µmol/min (condition C), and 1786.6 µmol/min (condition D).

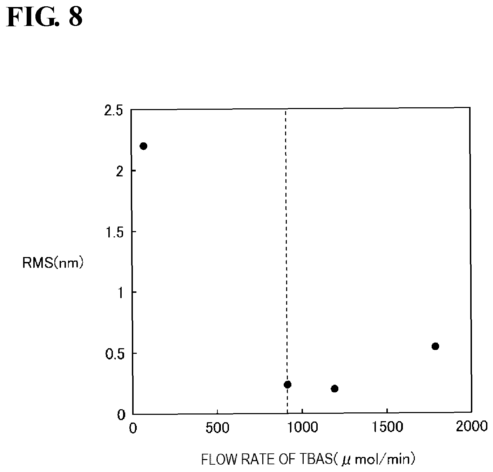

After the step S80 and before the step S90, the surface roughness RMS of the surface (second main surface 43B of third semiconductor layer 43) of obtained semiconductor stack 1 was measured. The surface roughness was measured by using a two beam interference objective lens (50 times) in an optical interference microscope system (BW-S505) manufactured by NIKON CORPORATION. The results of the experiment are shown in FIG. 8.

In FIG. 8, the horizontal axis corresponds to the flow rate of TBAs in the step S70. The vertical axis corresponds to the surface roughness of second main surface 43B of third semiconductor layer 43. Referring to FIG. 8, it is understood that the surface roughness is clearly improved by setting the flow rate of TBAs in the step S70 to be equal to or higher than the flow rate of TBAs in the step S60 (conditions B, C and D), as compared with the case where the flow rate of TBAs in the step S70 is lower than the flow rate of TBAs in the step S60 (flow rate is 77.4 µmol/min; condition A). From this, it is confirmed that the surface roughness can be improved by setting the flow rate of the source gas of As in the step S70 (sixth step) to be equal to or higher than that in the step S60 (fifth step).

In the above-described embodiment and examples, semiconductor laser 100 which is an edge emitting laser has been described as an example of the optical semiconductor device of the present disclosure. However, the optical semiconductor device of the present disclosure is not limited thereto. The optical semiconductor device of the present disclosure may be another semiconductor laser such as a surface emitting laser, or may be a light receiving element (photodiode).

It should be understood that the embodiments and examples disclosed herein are illustrative in all respects and not restrictive in any respect. The scope of the present invention is defined by the scope of the claims, not by the above description, and is intended to include all modifications within the meaning and scope equivalent to the scope of the claims.

### REFERENCE SIGNS LIST

1 semiconductor stack
10 base layer
11 substrate
11A first main surface
11B second main surface
12 n-type cladding layer
12A first main surface
12B second main surface
20 active layer
20A first main surface
20B second main surface
30 InP layer
30A first main surface
30B second main surface
40 p-type contact layer
41 first semiconductor layer
41A first main surface
41B second main surface
42 second semiconductor layer
42A first main surface
42B second main surface
43 third semiconductor layer
43A first main surface
43B second main surface
50 insulating film
50A first main surface
50B second main surface
50C opening
61 p-electrode
62 n-electrode
100 semiconductor laser
411 first layer
412 second layer
α arrow

## Claims

1. A semiconductor stack comprising:
a base layer formed of a III-V compound semiconductor;
an active layer formed of a III-V compound semiconductor;
an InP layer having a p-type conductivity;
a first semiconductor layer formed of InGaAsP containing a first impurity which is a p-type impurity other than carbon at a higher concentration than carbon;
a second semiconductor layer formed of InGaAs containing a second impurity which is a p-type impurity other than carbon and having a thickness of 20 nm or more; and
a third semiconductor layer formed of InGaAs containing carbon at a concentration of 3 × 10¹⁹ cm⁻³ or more,
wherein the base layer, the active layer, the InP layer, the first semiconductor layer, the second semiconductor layer, and the third semiconductor layer are stacked in this order,
the second semiconductor layer is in contact with the first semiconductor layer and the third semiconductor layer, and
a concentration of the second impurity in the second semiconductor layer is lower than a concentration of carbon at an interface with the third semiconductor layer and is higher than the concentration of carbon at an interface with the first semiconductor layer.

2. The semiconductor stack according to claim 1, wherein a surface roughness of a main surface of the third semiconductor layer opposite to the second semiconductor layer is 0.3 nm or less in terms of root mean square roughness.

3. The semiconductor stack according to claim 1, wherein the first impurity is Zn.

4. The semiconductor stack according to claim 1, wherein the second impurity is Zn.

5. The semiconductor stack according to claim 1, wherein a composition of InGaAsP forming the first semiconductor layer is such that a bandgap is smaller in a region closer to the second semiconductor layer than to the InP layer in a thickness direction of the first semiconductor layer.

6. The semiconductor stack according to claim 5, wherein the composition of InGaAsP forming the first semiconductor layer changes stepwise in the thickness direction of the first semiconductor layer such that atomic fractions of Ga and As in InGaAsP increase toward the second semiconductor layer.

7. The semiconductor stack according to claim 5, wherein the composition of InGaAsP forming the first semiconductor layer changes continuously in the thickness direction of the first semiconductor layer such that atomic fractions of Ga and As in InGaAsP increase toward the second semiconductor layer.

8. An optical semiconductor device comprising:
the semiconductor stack according to any one of claims 1 to 7; and
an electrode disposed on the third semiconductor layer.

9. A method of manufacturing a semiconductor stack, the method comprising:
a first step of preparing a base layer formed of a III-V compound semiconductor;
a second step of forming an active layer formed of a III-V compound semiconductor;
a third step of forming an InP layer having a p-type conductivity;
a fourth step of forming a first semiconductor layer formed of InGaAsP containing a first impurity which is a p-type impurity other than carbon at a higher concentration than carbon;
a fifth step of forming, at a first temperature, a second semiconductor layer formed of InGaAs containing a second impurity which is a p-type impurity other than carbon and having a thickness of 20 nm or more;
a sixth step of cooling the base layer, the active layer, the InP layer, the first semiconductor layer, and the second semiconductor layer from the first temperature to a second temperature lower than the first temperature; and
a seventh step of forming, at the second temperature, a third semiconductor layer formed of InGaAs containing carbon at a concentration of 3 × 10¹⁹ cm⁻³ or more,
wherein the first step, the second step, the third step, the fourth step, the fifth step, the sixth step, and the seventh step are performed in this order.

10. The method of manufacturing a semiconductor stack according to claim 9, wherein in the sixth step, a source gas of As is supplied at a flow rate equal to or higher than that in the fifth step.

11. The method of manufacturing a semiconductor stack according to claim 9 or 10, wherein after the seventh step, a surface roughness of a main surface of the third semiconductor layer opposite to the second semiconductor layer is 0.3 nm or less in terms of root mean square roughness.
